Europäisches Patentamt

European Patent Office

Office européen des brevets

(19)

(11) Veröffentlichungsnummer: **0 003 527**
**B1**

(12) **EUROPÄISCHE PATENTSCHRIFT**

(45) Veröffentlichungstag der Patentschrift: **19.05.82**

(51) Int. Cl.³: **H 01 J 37/304**

(21) Anmeldenummer: **79100201.7**

(22) Anmeldetag: **24.01.79**

(54) Verfahren und Anordnung zur Fokussierung eines Ladungsträgerstrahls auf Halbleiterplättchen.

(30) Priorität: **13.02.78 US 877198**

(43) Veröffentlichungstag der Anmeldung:
**22.08.79 Patentblatt 79/17**

(45) Bekanntmachung des Hinweises auf die Patenterteilung:
**19.05.82 Patentblatt 82/20**

(84) Benannte Vertragsstaaten:
**DE FR GB**

(56) Entgegenhaltungen:
**DE - A - 2 056 620**
**US - A - 3 924 156**

(73) Patentinhaber: **International Business Machines Corporation**
**Armonk, N.Y. 10504 (US)**

(72) Erfinder: **Albrecht, Drew Edward**
**151 Rt. 206 Bldg. 4 Apt. 9**
**Flanders NJ 07386 (US)**
Erfinder: **Doran, Samuel Kay**
**Box 36 Road No. 1**
**Putnam Valley, NY 10579 (US)**
Erfinder: **Michail, Michel Salib**
**Laurel Park Road No. 3**
**Wappingers Falls NY 12590 (US)**
Erfinder: **Yourke, Hannon Stanley**
**49 Croft Road**
**Poughkeepsie NY 12603 (US)**

(74) Vertreter: **Böhmer, Hans Erich, Dipl.-Ing.**
**Schönaicher Strasse 220**
**D-7030 Böblingen (DE)**

Courier Press, Leamington Spa, England.

## Verfahren und Anordnung zur Fokussierung eines Ladungsträgerstrahls auf Halbleiterplättchen

Die Erfindung betrifft ein Verfahren und eine Anordnung zur Fokussierung eines Ladungsträgerstrahls auf Halbleiterplättchen, auf deren Oberfläche der Strahl ein Muster schreibt, und die Ausrichtmarken aufweisen, die durch den Strahl abgetastet und zur Berechnung von eine Verschiebung des Musters in der Plättchenebene gegenüber einer Sollposition, eine Verdrehung des Musters um eine Senkrechte zur Plättchenebene gegenüber einer Solldrehlage, eine Verzerrung des Musters gegenüber einer Sollform und einen Maßstabfehler des Musters bei Abweichung der Höhenlage der Plättchenebene von einer Sollebene definierenden Faktoren verwendet werden.

In der DE—A 20 56 620 ist ein Verfahren und eine Anordnung für die Steuerung eines Ladungsträgerstrahls mit quadratischem Querschnitt beschrieben. Dieser Strahl wird sowohl zum Schreiben von Mustern auf Halbleiterplättchen, auf einer Halbleiterscheibe oder auf einer Maske, als auch zum Feststellen der Position eines jeden Halbleiterplättchens in bezug auf eine vorbestimmte Position durch die Bestimmung der Position von Paaren von Ausrichtmarken für jedes Halbleiterplättchen mit Hilfe des Elektronenstrahls benutzt. In dieser Patentanmeldung stellt die Bestimmung des Ortes von zwei Ausrichtmarken sicher, daß das Muster innerhalb des Halbleiterplättchens geschrieben werden kann.

In der DE—A 25 02 431 ist ein verbessertes Verfahren und eine entsprechende Anordnung offenbart, wodurch ein einziges Muster in mehr als einem Schreibfeld geschrieben werden kann, statt daß dieser Vorgang auf ein Schreibfeld begrenzt ist. Somit können also mit dem dort offenbarten Verfahren und der zugehörigen Anordnung auf einer Halbleiterscheibe fortlaufende Muster, die größer sind als das Feld, das durch den Strahl beschrieben werden kann, mit der notwendigen Genauigkeit geschrieben werden. Dies wird durch Verwendung einer Anzahl quadratischer oder rechteckiger Felder erreicht, wobei jedes Feld sich jedem der benachbarten Felder überlagert. Somit hat jedes Feld, das nicht am Umfang der Halbleiterscheibe liegt, einen Bereich, der sich mit ähnlichen Bereichen von vier anderen benachbarten Feldern überlappt. In jeder der vier Ecken jedes Feldes ist eine Ausrichtmarke angeordnet, die dabei auch in dem überlappenden Bereich der benachbarten Felder liegt.

Obgleich es im Prinzip erwünscht ist, daß jede dieser Ausrichtmarken an einer vorbestimmten Stelle liegt, so daß die Ausrichtmarken ein vierseitiges, rechteckiges oder quadratisches Feld definieren, bei dem die Ausrichtmarken in den jeweiligen Ecken liegen, so gibt es doch gewöhnlich bei jeder dieser Marken eine geringfügige Abweichung von der vorgesehenen Lage, da die Ausrichtmarken mit einer gewissen Toleranz auf der Halbleiterscheibe geschrieben werden. Daher liegen die Ausrichtmarken gewöhnlich nicht an der durch den Entwurf festgelegten Position, sondern weichen von dieser etwas ab. Stellt man die Abweichung einer jeden der vier Ausrichtmarken für ein bestimmtes Feld von den durch Entwurf festgelegten Positionen für die Ausrichtmarken fest, dann hat man damit die Grenzen des zu beschreibenden Feldes festgelegt.

Da der Strahl jedoch entsprechend einem vorbestimmten Muster angelegt wird, bei dem das Feld als vollkommenes Quadrat oder Rechteck angenommen wird, haben diese Abweichungen der Ausrichtmarken für ein bestimmtes Feld zur Folge, daß das Feld tatsächlich kein vollkommenes Quadrat oder Rechteck ist. Würde man daher den Strahl gemäß dem vorbestimmten Muster anlegen, dann würde der Strahl möglicherweise über die durch die Ausrichtmarken definierten Grenzen hinausgeführt und in einem anderen Feld angelegt werden, wenn keine Korrektur durchgeführt würde.

Während die Muster für das Schreiben innerhalb eines bestimmten Feldes sicherlich so ausgelegt wären, daß der Strahl selbst bei Abweichungen der Ausrichtmarken nicht über das zu beschreibende Feld hinausgeführt würde, so kann man sich darauf dann nicht verlassen, wenn man ein einziges Muster in mehr als einem Feld schreibt. Der Grund dafür ist, daß wegen der erforderlichen Genauigkeit des Strahls in bezug auf die Feldgröße der Strahl in jedem Feld für sich angelegt werden muß. Somit muß jede durch den Strahl geschriebene Linie an einer bestimmten Grenze enden, so daß beim Anlegen des Strahls an das nächste benachbarte Feld der Strahl als Fortsetzung des vorhergehenden Endpunktes des Strahls an der Grenze zwischen den beiden benachbarten Feldern angelegt wird.

Um daher sicherzustellen, daß der Strahl innerhalb der durch die tatsächlichen Orte der Ausrichtmarken in bezug auf den Strahl definierten Grenzen des Feldes angelegt wird, ist eine dynamische Korrektur der Position des Strahls dann erforderlich, wenn er von einer vorbestimmten Position innerhalb des Feldes zur nächsten weiterbewegt wird, so daß der Strahl an der tatsächlichen Position auftrifft, die entsprechend der tatsächlichen Lage des Feldes, wie sie durch die vier Ausrichtmarken des Feldes bestimmt ist, von der vorbestimmten Position abweicht. Durch diese dynamische Korrektur bei jeder der vorbestimmten Positionen schreibt der Strahl das Muster innerhalb der Grenzen des Feldes, wie es durch die tatsächlichen Orte der Ausrichtmarken bestimmt ist.

Wird in den Feldern dadurch geschrieben, daß der Strahl sich von einem Feld in X-Richtung nach dem nächstbenachbarten Feld in X-Richtung und nach rechts bewegt, dann sind die Ausrichtmarken in der unteren und oberen Ecke des ersten Feldes die Ausrichtmarken in der oberen und unteren Ecke des nächst anschließenden Feldes. Diese beiden Ausrichtmarken legen damit die gemeinsame Grenze zwischen den beiden Feldern fest und dienen als Bezugspunkte, an denen der Strahl bei dem nächsten der anstoßenden Felder angelegt wird. Die andern Grenzen des Feldes sind in gleicher Weise in bezug auf die Ausrichtmarken anderer benachbarter Felder definiert.

Es sei darauf hingewiesen, daß die Bezugspunkte in bezug auf die tatsächlichen Orte der Ausrichtmarken festgestellt werden können, die für die Festlegung der Grenzen des Feldes benutzt werden, anstelle der Ausrichtmarken selbst. Diese Verschiebung würde in einem angeschlossenen Rechner durchgeführt, hätte jedoch auf das Einschreiben eines Musters innerhalb eines Feldes, das durch die vier Ausrichtmarken an den Ecken des Feldes definiert ist, keinen Einfluß.

Durch Feststellung des tatsächlichen Ortes einer jeden der Ausrichtmarken eines Feldes können verschiedene digitale Konstante bestimmt und während des Schreibens des Musters innerhalb eines bestimmten Feldes benutzt werden. Diese digitalen Konstanten werden für eine Korrektur der Verschiebung, des Maßstabes, der Verdrehung und Verzerrung des Strahls in X- und Y-Richtung eingesetzt. Verwendet man die Ablenkspannungen für die magnetische Ablenkung in X- and Y-Richtung an jedem der vorbestimmten Punkte, an denen der Strahl angelegt werden soll, und modifiziert man diese Ablenk Spannungen durch die entsprechenden digitalen Konstanten für das bestimmte Feld, dann werden für X- und Y-Richtung an einem Satz elektrostatischer Ablenkplatten Korrekturspannungen angelegt, die den Strahl von der vorbestimmten Position nach der tatsächlich verschobenen Position gemäß dem durch den tatsächlichen Ort der Ausrichtmarken bestimmten tatsächlichen Feld verschieben.

Durch das Anlegen der Korrekturspannung zur Verschiebung des Strahls wird dieser innerhalb der Grenzen des Feldes geschrieben, da der Strahl beispielsweise in jeder Linie entweder komprimiert oder gedehnt würde, um den Unterschied zwischen der vorbestimmten Position und der tatsächlichen Position zu berücksichtigen.

Die in der DE—A 25 02 431 beschriebene Anordnung eignet sich dann insbesondere gut, wenn eine Anzahl von Mustern in verschiedenen Ebenen eines Halbleiterplättchens geschrieben werden muß, wobei jede Ebene zu einem anderen Zeitpunkt geschrieben wird. Dadurch kann zwischen den in verschiedenen Ebenen in einem Halbleiterplättchen geschriebenen Feldern eine große Genauigkeit der gegenseitigen Deckung oder Ausrichtung erreicht werden.

Dies wird dadurch erzielt, daß man den tatsächlichen Ort jeder der vier Ausrichtmarken eines Feldes, wie zuvor erwähnt, feststellt und für die verschiedenen Schreibebenen diese tatsächlichen Orte als Bezugspunkte beibehält. Sollte die Verwendung eines neuen Satzes von Ausrichtmarken erforderlich werden, dann würden diese in der Weise eingeschrieben werden, daß ihre tatsächlichen Orte in bezug auf die tatsächlichen Orte vorher benutzter Ausrichtmarken bestimmt würden, die das Feld definieren. Wenn man daher die digitalen Konstanten für die Korrektur der Verschiebung, der Maßstabes, der Verdrehung und der Verzerrung des Strahls in X- und Y-Richtung einsetzt, dann kann der Strahl immer von seiner vorbestimmten Position nach seiner tatsächlichen verschobenen Position verschoben werden, unabhängig von der Ebene, in der das Muster geschrieben wird, so daß auf diese Weise sichergestellt wird, daß das Muster in jeder Ebene genau über den anderen Mustern in anderen Ebenen dieses Feldes liegt.

In den oben genannten DE—A 20 56 620 und DE—A 25 02 431 sind Anordnungen beschrieben, mit denen mit Erfolg in mehrfach übereinander liegenden Schichten oder Ebenen von Halbleiterplättchen geschrieben werden kann, wobei jedoch die zu beschreibenden Halbleiterscheiben relativ eben sind. Halbleiterscheiben neigen jedoch wegen der in anderen Stufen der Halbleiterfertigung eingesetzten Wärmebehandlungen zu Verwerfungen. Daher haben Halbleiterscheiben, die mit Hilfe von Elektronenstrahlsystemen bearbeitet und an den Orten von mehreren Halbleiterplättchen beschrieben werden müssen, oft beträchtliche Verwerfungen. Solche Verwerfungen haben zur Folge, daß eine gegebene Oberfläche eines Halbleiterplättchens nicht mehr in der Brennebene des Elektronenstrahls leigt. Das hat weider Ungenauigkeiten zur Folge, die in den bekannten Systemen nicht kompensiert werden können.

Außerdem kommt es auch noch vor, daß beim Schreiben mit Masken in einem Elektronenstrahlsystem eine gewisse Neigung der Masken auftritt, die ebenfalls Schierigkeiten bereitet. Diese Schwierigkeit läßt sich in den bisher bekannten Systemen nicht lösen.

Aufgabe der Erfindung ist es somit, bei einem Verfahren und einer Anordnung der oben genannten Art eine Korrektur der Fokussierung eines Elektronenstrahls zur Anpassung an die Oberfläche einer vorgegebenen Halbleiterscheibe am Ort eines jeden Halbleiterplättchens durchzuführen.

Dies wird bei einem Verfahren der eingangs genannten Art dadurch erreicht, daß nach Maßgabe des Maßstabfehler-Faktors ein elektrisches Korrektursignal gebildet und dieses einer Fokussierspule zugeführt wird, die die Höhenlage des Ladungsträgerstrahl-Brennpunktes an die Isthöhe des jeweiligen Halbleiterplättchens angleicht.

Die dazu verwendete Anordnung zeichnet sich dadurch aus, daß an Rechenschaltungen zur Berechnung des scheinbaren Maßstabfehlerfaktors ein Digital/Analog-Wandler angeschlossen ist, dessen Ausgangssignal als Höhenkorrektursignal an einem Eingang eines mit dem anderen Eingang geerdeten rückgekoppelten Differentialverstärkers anliegt, der ausgangsseitig mit der Fokussierspule verbunden ist.

Die Erfindung wird nunmehr anhand eines Ausführungsbeispiels in Verbindung mit den beigefügten Zeichnungen näher erläutert.

In den Zeichnungen zeigt

Fig. 1 eine schematische Darstellung eines Elektronenstrahlerzeugungssystems mit Einrichtungen zur Steuerung des Strahls,

Fig. 2 schematisch ein Blockschaltbild einer Schaltungsanordnung für die dynamische Abgabe von Signalen zur Erzeugung und Abgabe von Fokussierstrom-Korrektursignalen an die dynamische Fokussierspule des Systems gemäß Fig. 1,

Fig. 3 eine schematische Darstellung der Beziehung zwischen einem tatsächlichen Feld, an dem der Strahl angelegt werden soll, und dem Feld, an dem der Strahl ohne dynamische Korrektur für den Ort der Ausrichtmarken angelegt werden würde,

Fig. 4 eine Draufsicht eines Teils einer Halbleiterscheibe mit Feldern, an denen der Strahl angelegt werden soll, mit einer Andeutung sich überlappender Felder,

Fig. 5 eine vergrößerte Draufsicht einer Ausrichtmarke, die eine Ecke eines Feldes definiert, in dem der Elektronenstrahl schreiben kann, und

Fig. 6 eine schematische Darstellung eines Elektronenstrahls in bezug auf den Ort eines Halbleiterplättchens zur Erläuterung des Auftretens eines Höhenfehlerfaktors in bezug auf die Nennebene im Gegensatz zur natürlichen Auftreffebene.

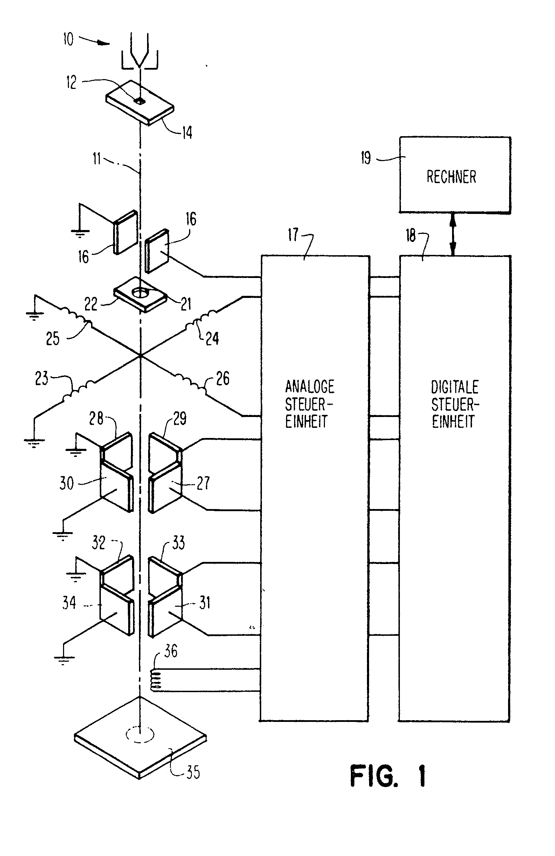

In Fig. 1 ist ein Elektronenstrahlerzeugungssystem 10 dargestellt, das in bekannter Weise einen Ladungsträgerstrahl 11 erzeugt, der eine dem Strahl seine Form gebende Blende 12 in einer Platte 14 durchläuft. Der Querschnitt des Strahls 11 ist vorzugsweise quadratisch und entspricht in seiner Seitenlänge der kleinsten Linienbreite des zu bildenden Musters. Der Strahl kann aber auch einen rechteckigen oder anderen Querschnitt aufweisen. Der Strahl 11 durchläuft ein Paar Austastplatten 16, die bestimmen, wann der Strahl 11 an das zu beschreibende Material angelegt und wann er ausgetastet wird. Die Austastplatten werden durch Schaltungen in der Analogsteuereinheit 17 gesteuert, die wiederum durch eine digitale Steuereinheit 18 gesteuert wird, wie dies beispielsweise in der DE—A 24 43 625 beschrieben ist. Die digitale Steuereinheit 18 ist an einem Rechner 19 angeschlossen, der vorzugsweise eine Datenverarbeitungsanlage des IBM Systems /370 ist.

Der Ladungsträgerstrahl 11 durchläuft dann eine kreisförmige Blende 21 in einer Platte 22. Dies hat zur Folge, daß nur diejenigen geladenden Teilchen, die die Mitten von Linsen (nicht gezeigt) durchlaufen, benutzt werden, so daß ein quadratischer Fleck ohne Verzerrungen erzeugt wird.

Der Strahl 11 durchläuft dann magentische Ablenkspulen 23, 24, 25 und 26, die die Ablenkung des Strahls 11 in horizontaler oder X-Richtung bzw. in vertikaler oder Y-Richtung steuern. Die Ablenkspulen 23 bis 26 bewirken also durch entsprechende Ablenkung des Strahls eine horizontale Abtastbewegung.

Obgleich der Strahl 11 rasterartig bewegt werden könnte, wird er doch vorzugsweise so hin- und herbewegt, daß sich der Strahl 11 in benachbarten Zeilen in entgegengesetzten Richtungen bewegt. Während der Vorwärtsabtastung wird den Ablenkspulen 23 und 24 eine negativ kompensierte Sägezahnspannung einer Polaritat zugeführt, während den Ablenkspulen 23 und 24 während der rückwärts gerichteten Abtastung eine positiv kompensierte Sägezahnspannung von entegengesetzter Polarität zugeführt wird.

Der Strahl 11 durchläuft dann einen ersten Satz von elektrostatischen Ablenkplatten 27, 28, 29 und 30, wobei die elektrostatischen Ablenkplatten 27 und 28 eine Ablenkung des Strahls in waagerechter oder X-Richtung bewirken, während die elektrostatischen Ablenkplatten 29 und 30 eine Bewegung des Strahls 11 in senkrechter oder Y-Richtung bewirken.

Die Ablenkplatten 27 bis 30 sollen dabei jede gewünschte Verschiebung des Strahls an jedem der vorbestimmten Punkte bweirken können, nach denen der Strahl bewegt wird.

Nach Durchlaufen der elektrostatischen Ablenkplatten 27 bis 30 durchläuft der Strahl einen zweiten Satz elektrostatischer Ablenkplatten 31, 32, 33 und 34. Die elektrostatischen Ablenkplatten 31 und 32 bewirken eine Ablenkung des Strahls in waagerechter oder X-Richtung, während die Ablenkplatten 33 und 34 eine Ablenkung des Strahls in senkrechter oder Y-Richtung bewirken. Die Platten 31 und 32 lenken daher den Strahl 11 in X-Richtung, und die Platten 33 und 34 lenken den Strahl 11 in Y-Richtung aus jeder der vorbestimmten Positionen ab, in die der Strahl gemäß dem vorbestimmten Muster abgelenkt wird, so daß der Strahl 11 in seiner tatsächlichen Position auf der Grundlage der Abweichung von dem Bereich von seiner vorbestimmten Position in Form und Ort angelegt wird, an dem der Strahl 11 schreiben soll.

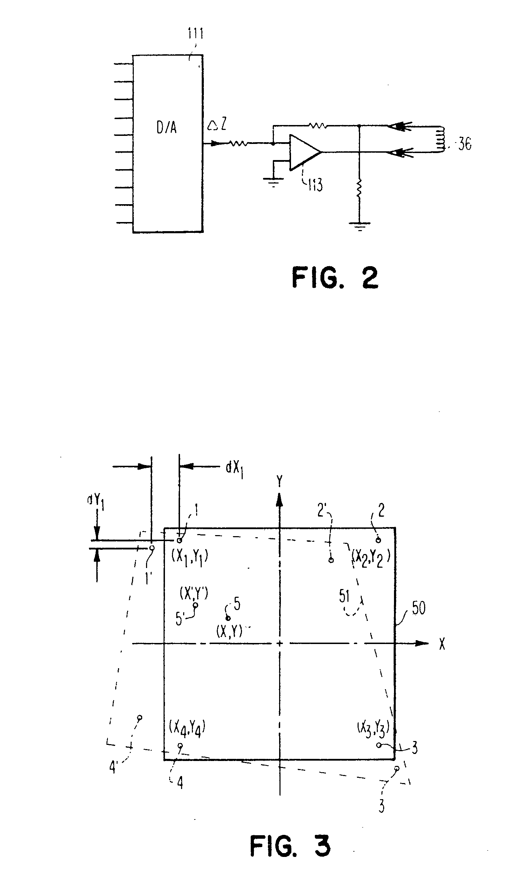

Nach Durchlaufen der Ablenkplatten 31 bis 34 durchläuft der Strahl eine Fokussierspule 36. Dieser Fokussierspule 36 wird ein Höhenfehler-Korrektursignal zur Korrektur der Höhenlage des Brennpunktes des Strahls an einem vorgegebenen Ort eines Halbleiterplättchens für eine unebene Halbleiterscheibe zugeführt. Die Fokussierspule ist dabei an der Analogsteuereinheit 17 und der digitalen Steuereinheit 18 in der Weise angeschlossen, wie dies im einzelnen in Verbindung mit Fig. 1 und 2 noch zu beschreiben ist.

Der Strahl 11 wird dann an die Halbleiterscheibe angelegt, die auf einem Tisch 35 liegt. Der Tisch 35 ist dabei in X- und Y-Richtung verscheibbar.

Der Strahl 11 wird dabei durch A, B und C-Zyklen bewegt, wie dies in der DE—A 20 56 620 beschrieben ist, und es werden Signale zugeführt, die den Strahl 11 von jeder der vorbestimmten Soll-Positionen, nach denen er schrittweise weiterbewegt wird, während des B-Zyklus, wenn das Muster geschrieben wird, nach einer davon abweichenden tatsächlichen oder Ist-Position verschieben, die durch den Ort eines tatsächlichen Feldes im Vergleich mit dem Ort des durch Entwurf festgelegten Feld es bestimmt ist.

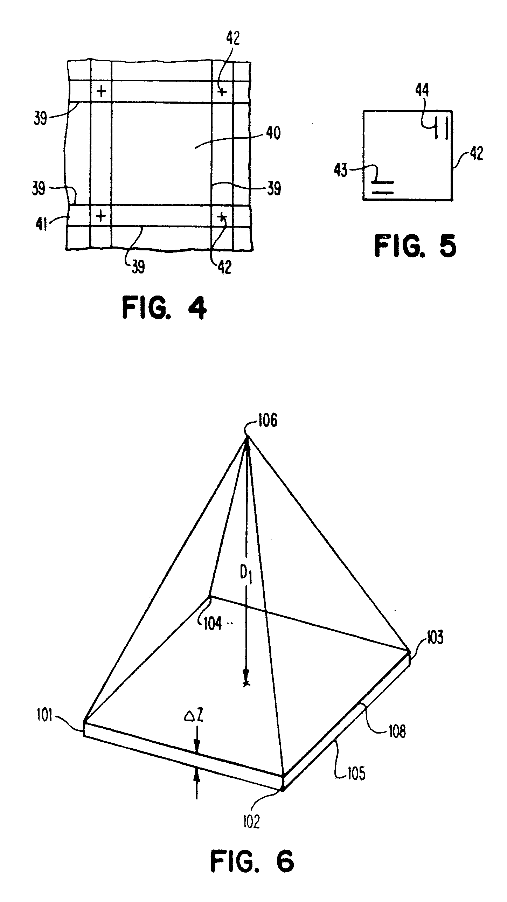

Wie aus Fig. 4 zu erkennen, kann die Auffangelektrode oder das Werkstück eine Anzahl von Feldern 39 aufweisen, die einander überlappen. Innerhalb jedes der Felder 39 kann dabei ein Halbleiterplättchen 40 gebildet werden, so daß sich auf einer Halbleiterscheibe 41 eine Anzahl von Halbleiterplättchen 40 befindet, wobei z. B. jedes der Halbleiterplättchen 40 mit Photolack überzogen ist, der durch den Ladungsträgerstrahl 11 belichtet werden soll.

Selbstverständlich kann jedes Halbleiterplättchen 40 auch aus einer Anzahl von Feldern 39 bestehen, oder ein Feld 39 kann mehrere Halbleiterplättchen 40 enthalten. Die nachfolgende Beschreibung geht davon aus, daß in jedem der Felder 39 ein Halbleiterplättchen 40 gebildet ist.

An jeder der vier Ecken eines jeden Feldes ist eine in Fig. 4 schematisch als Kreuz dargestellte Ausrichtmarke 42 vorgesehen. Man sieht ferner aus Fig. 4, daß das überlappen der benachbarten Felder 39 zur Folge hat, daß die gleichen Ausrichtmarken 42 für jedes der vier anschließenden benachbarten Felder 39 benutzt werden. Die Ausrichtmarke 42 in der unteren rechten Ecke des einzigen vollständigen in Fig. 4 gezeigten Feldes 39 stellt außerdem die Ausrichtmarke in der unteren linken Ecke des sich nach rechts von dem vollständigen Feld 39 anschließenden Feldes 39, die obere rechte Ecke des unterhalb des vollständigen Feldes 39 liegenden Feldes und die obere linke Ecke des sich diagonal an das vollständige Feld anschließenden Feldes 39 dar.

Jede der Ausrichtmarken 42 wird vorzugsweise durch zwei waagerecht verlaufende Streifen 43 in Fig. 5 und vorzugweise durch zwei senkrecht verlaufende Streifen 44 gebildet, wobei in jedem Fall die Anzahl der Streifen in waagerechter und senkrechter Richtung gleich groß sein sollte. Man kann auch andere geeignete Anordnungen von Ausrichtmarken verwenden, bei denen senkrecht verlaufende Kanten der Ausrichtmarke in X-Richtung und waagerecht verlaufende Kanten der Ausrichtmarke in Y-Richtung abgetastet werden Können.

Die sich überlappenden Felder 39 machen ein Schreiben auch in die benachbarten Felder hinein moglich. Die Grenze eines jeden Halbleiterplättchens 40 liegt innerhalb des überlappten Bereichs des Feldes 39 des Halbleiterplättchens 40 und wird normalerweise durch die sich zwischen den Ausrichtmarken 42 erstreckenden Linien definiert.

Der genaue Ort einer jeder Ausrichtmarke 42 wird dadurch erhalten, daß der Elektronenstrahl die senkrechten Kanten der senkrecht verlaufenden Streifen 44 der Ausrichtmarke 42 während der Abtastung in X-Richtung und die waagerecht verlaufenden Kanten der waagerecht liegenden Streifen 43 der Ausrichtmarke während der Abtastung in Y-Richtung überfährt.

Wenn die Ausrichtmarken 42 an den im Entwurf festgelegten Punkten liegen, dann würde das durch die Ausrichtmarken 42 auf diese Weise bestimmte Feld an den Positionen 1, 2, 3 und 4 in Fig. 3 und 4 in Fig. 3 liegen, und der Strahl würde in diesem Feld angelegt werden. Das durch Entwurf festgelegte Feld wäre dabei ein vollkommenes Quadrat oder Rechteck.

Wegen verschiedener Einflüsse, wie zum Beispiel des Zustandes der Oberfläche der Halbleiterscheibe 41, des Materials der Halbleiterscheibe 41 auf einer bestimmten Ebene, der Neigung der Halbleiterscheibe, einer möglichen Verdrehung der Halbleiterscheibe, Einstellfehler des Elektronenstrahls und Fehlern beim Anbringen der Ausrichtmarken 42, befinden sich die Ausrichtmarken 42 nicht an den im Entwurf festgelegten Punkten 1, 2, 3 und 4 in Fig. 3. Statt dessen liegen die Ausrichtmarken wegen dieser verschiedenen Einflüsse, beispielsweise an Punkten 1', 2', 3' und 4', wie dies Fig. 3 zeigt. Das hat zur Folge, daß durch die Ausrichtmarken 42 an den Punkten 1', 2', 3' und 4″ anstelle der im Entwurf festgelegten Punkte 1, 2, 3 und 4 ein tatsächliches Feld 51 gebildet wird, das nicht notwendigerweise ein vollständiges Quadrat oder ein vollständiges Rechteck ist, jedoch vier Seiten aufweist und von dem Strahl 11 beschrieben werden kann.

Wenn ein Muster sowohl auf dem Halbleiterplättchen 40 innerhalb des Feldes 51 und dem Halbleiterplättchen 40 innerhalb des rechts vom Feld 51 liegenden Feldes geschrieben werden soll, dann muß die Linie zwischen den Punkten 2' und 3' genau definiert sein, so daß der Strahl 11 die gleichen Linien innerhalb des Feldes 51 in dem rechts davon liegenden Feld 51 fortsetzt. Die durch die Punkte 2' und 3' definierte Linie stellt dabei die Grenze zwischen dem Halbleiterplättchen 40 innerhalb des Feldes 51 und dem Halbleiterplättchen 40 innerhalb des rechts vom Feld 51 gelegenen Feldes dar, so daß dies die gemeinsame Grenze zwischen zwei Halbleiterplättchen 40 darstellt. Es sei darauf hingewiesen, daß die Fläche des Halbleiterplättchens 40, welche durch den Strahl 11 beschrieben wird, nicht das ganze durch die Position der Ausrichtmarken 42 bestimmte Feld sein muß, sondern kleiner sein kann, wobei dann die Ausrichtmarken 42 als Bezugspunkte dienen.

Der Unterschied zwischen den durch Entwurf festgelegten Orten und den tatsächlichen Orten der einzelnen Ausrichtmarken 42 kann durch den Unterschied zwischen den durch Entwurf bestimmten und den tatsächlichen Positionen der Marken 42 in X- und Y-Richtung definiert werden. Die Gleichungen für den Ort bestimmten Ausrichtmarke sind

$$dX = A + BX + CY + DXY \qquad (1)$$

und

$$dY = E + FX + GY + HXY \qquad (2)$$

In Gleichungen (1) und (2) stellt X die Entwurfsposition der Ausrichtmarke in X-Richtung und Y die Entwurfsposition der Ausrichtmarke in Y-Richtung der, während dX der Abstand zwischen der Entwurfsposition und der tatsächlichen Position in X-Richtung, und dY der Abstand zwischen der tatsächlichen Position und der Entwurfsposition in Y-Richtung darstellt. A, B, C, D, E, F, G und H sind digitale Konstanten, die für ein bestimmtes Feld, an das der Strahl 11 angelegt werden soll, ermittelt werden können.

Die digitale Konstante A stellt die Verschiebung des Strahls in X-Richtung dar, während die digitale Konstante E die Verschiebung des Strahls 11 in Y-Richtung bezeichnet. Die digitale Konstante B stellt den Maßstasfehler in X-Richtung und die digitale Konstante G den Maßstabsfehler in Y-Richtung dar. Die digitale Konstante C stellt den Verdrehungsfehler des Strahls 11 in X-Richtung und die digitale Konstante F den Verdrehungsfehler des Strahls in Y-Richtung dar. Die digitale Konstante D stellt die Verzerrung des Strahls in X-Richtung und die digitale Konstante H die Verzerrung des Strahls 11 in Y-Richtung dar.

In der DE—A2502431 sind die mathematischen Beziehungen der digitalen Konstanten und die mathematische Lösung zur Berechnung dieser digitalen Konstanten angegeben.

Somit werden die digitalen Konstanten A, B, C, D, E, F, G und H unter Verwendung der durch Entwurf festgelegten Positionen der Punkte 1, 2, 3 und 4 in X- und Y-Richtung, die für das durch Entwurf festgelegte Feld 50 bekannt sind, zusammen mit den tatsächlichen Abständen $dX_1$ bis $dX_4$ und $dY_1$ bis $dY_4$ zwischen den Positionen 1, 2, 3 und 4 und den Positionen 1', 2', 3' und 4' in X- und Y-Richtung ermittelt. Jede der Positionen des Strahls 11 innerhalb des Feldes 50 wird außerdem durch die Ablenkspannung für dic magnetische Ablenkung des Strahls 11 dieser bestimmten Position definiert.

Ist die Maßstabsfehler-Konstante definiert, dann ist die Fig. 6 für das Verständnis des Kompensationsverfahrens für die Brennpunktkorrektur nützlich. In Fig. 6 ist ein Halbleiterplättchen zwischen den vier Ausrichtmarken 101, 102, 103 und 104 in einer normalen Ebene 105 der Halbleiterscheibe dargestellt. Ein Arbeitsabstand D1 für die Ablenkung des Strahls ist als Abstand zwischen der normalen Abtastebene und dem Schwenkpunkt 106 des abzulenkenden Strahls definiert. Eine gleichartige Breite des Halbleiterplättchens wird durch eine unebene Oberfläche 108 definiert, die bei der Bearbeitung einer typischen Halbleiterscheibe erwartet werden kann.

Man erkennt aus der Figur 6, daß Ablenkwinkel des Strahls nach der Halbleiterscheibe sich zwischen den Ebenen 105 und 108 unterscheiden, ebenso die Bearbeitungsabmessungen. Außerdem ist der Höhenfehlerfaktor $\Delta Z$ in der Figur als die Abmessung definiert, um die der Brennpunkt am Ort dieses hier betrachteten Halbleiterplättchens korrigiert werden muß.

Wenn einmal der Höhenfehlerfaktor $\Delta Z$ berechnet ist, dann kann der dynamische Fokussierspulenstrom proportional dem Faktor $\Delta Z$ geändert werden, wodurch dann die Brennebene des Strahls zur Anpassung an die Ebene der Oberfläche eines bestimmten Halbleiterplättchens entsprechend verschoben wird. Wenn jedoch die Brennpunktkorrektur auf diese Weise durchgeführt wird, so sieht man sofort, daß sich damit auch der Maßstab ändert. Somit wird der am Ort des nächsten Halbleiterplättchens gemessene Maßstab eine auf den Höhenfehlerfaktor $\Delta Z$ zurückzuführende Komponente aufweisen sowie eine auf den zuvor eingeführten Brennpunktkorrekturfaktor zurückzuführende Komponente.

Der Korrekturfaktor $\Delta Z$ wird aus den Maßstabsfoeffizienten B und G wie folgt berechnet:

$$M_n = \frac{B + G}{2} \qquad (3)$$

wobei $M_n$ den durchschnittlichen Maßstabsfehler des n-ten Ortes eines Halbleiterplättchens, gemessen während der Ausrichtung, darstellt. Der Korrekturfaktor $\Delta Z_n$ wird durch die Gleichung 4 bestimmt

$$\Delta Z_n \, [mm] = K_1 M_n \, [mm] - K_2 \Delta Z_{n-1} \, [mm]$$

wobei $\Delta Z_{n-1}$ die Brennweitenkorrektur bei dem zuvor kompensierten Ort eines Halbleiterplättchens und $\Delta Z_o = o$ ist. Die Konstante K1 und die dimensionslose Konstante K2 hängen von dem tatsächlichen Arbeitsabstand und der Empfindlichkeit der dynamischen Fokussierspule ab. Es wurde festgestellt, daß für das beschriebene System ein dimensionsloser Wert von K2 von etwa 0.2 und ein Wert von K1 in der Größenordnung von 100 Millimeter ziemlich typisch sind.

Nachdem die digitalen Konstanten A, B, C, D, E, F, G und H für das tatsächliche Feld 51 ermittelt sind, lassen sich die Spannungen für die magnetische Ablenkung X und Y in Gleichung (1) für dX und in Gleichung (2) für dY substituieren, wodurch die an den Strahl 11 in jeder vorbestimmten Position (X, Y) zur Verschiebung des Strahls 11 nach der entsprechenden tatsächlichen Position (X′, Y′) anzulegende Ablenkspannung zu bestimmen ist. Daher ist dX die für die X-Richtung zur Verschiebung des Strahls 11 von seiner vorbestimmten Position X nach seiner tatsächlichen Position X′ anzulegende Ablenkspannung, und dY ist die zur Verschiebung des Strahls 11 in Y-Richtung von seiner vorbestimmten Position Y nach seiner tatsächlichen Position Y′ anzulegende Ablenkspannung.

Da demgemäß die Ablenkspannung für die magnetische Ablenkung an jeder der vorbestimmten Positionen, auf die der Strahl 11 beim Schreiben eines Musters abgelenkt wird, verschieden ist, ermöglicht die Substitution der X- und Y- Ablenkspannungen in Gleichungen (1) und (2) die Bestimmung von dX und dY für jede Position des zu schreibenden Musters. Damit können auch die Korrekturen mit den Ablenkspannungen für die magnetische Ablenkung korreliert werden.

Die durch Lösung der Gleichung (1) für dX ermittelte Spannung ist die an den elektrostatischen Ablenkplatten 31 und 32 angelegte Ablenkspannung, und die durch Lösung der Gleichung (2) für dY errechnete Ablenkspannung liegt an den elektrostatischen Ablenkplatten 33 und 34. Die Ablenkspannungen bewirken daher an jeder der vorbestimmten Positionen eine Verschiebung des Strahls 11 für eine dynamische Korrektur der Ablenkung des Strahls 11 an jeder der vorbestimmten Positionen, nach denen der Strahl 11 weitergeschaltet wird, so daß sich der Strahl 11 nach den tatsächlich verschobenen Positionen bewegt, wodurch das vorbestimmte Muster in dem tatsächlich vorhandenen Feld 51 und nicht in dem durch Entwurf festgelegten Feld 50, für das das Muster in dem Rechner 19 programmiert wurde, eingeschrieben wird.

Somit ist es zum Einschreiben des vorbestimmten Musters innerhalb des tatsächlichen Feldes 51 anstelle des durch Entwurf festgelegten Feldes 50 notwendig, ständig für jede Position innerhalb des Feldes die Ablenkspannungen für die magnetische Ablenkung für X und Y zu bestimmen. Nach Bestimmung der entsprechenden Korrekturspannungen (dX und dY) und nach Substitution der Ablenkspannungen X und Y in Gleichungen (1) und (2) werden die Korrekturspannungen dX den elektrostatischen Ablenkplatten 31 und 32 für die X-Richtung und die Korrekturspannung dY den elektrostatischen Ablenkplatten 33 und 34 für die Y-Richtung zugeführt.

Gleichzeitig werden über Gleichungen (3) und (4) der Fokussierfehler in ΔZ oder der Höhenfehlerfaktor berechnet, und der Fokussierspule 36 wird ein Strom zugeführt, womit für eine dynamische Fokuskorrektur oder Brennweitenkorrektur ständig ein Korrektursignal zugeführt wird.

Durch die in der DE—A 24 43 625 offenbarten Schaltungen werden die berechneten Werte der Korrekturkonstanten A bis H dem Strahl zugeführt. Außerdem wird zum Anlegen des Höhenfehlerkorrektursignals ΔZ die in Fig. 2 dargestellte Schaltung benutzt.

Fig. 2 zeigt einen Digital/Analog-Wandler 111, der ausgangsseitig an einem Eingang eines Differentialverstärkers 113 angeschlossen ist. Der andere Eingang des Differentialverstärkers liegt an Masse. Das Ausgangssignal des Differentialverstärkers wird der in Fig. 1 gezeigten Fokussierspule 36 zugeführt.

Am Eingang des Digital/Analog-Wandlers 111 liegen die von der digitalen Steuereinheit 18 und dem Rechner 19 kommenden Eingangssignale, wie dies die oben genannte Deutsche Patentanmeldung offenbart. Diese Eingangssignale sind tatsächlich die berechneten Werte für B und G aus denen die besonderen Korrekturfaktoren für den Maßstabsfehler und damit für den Höhenfehler ΔŻ, die der Fokussierspule 36 zugeführt werden, abgeleitet werden können.

Es wurde festgestellt, daß das hier angegebene Verfahren und die hier beschriebene Anordnung für unregelmäßig verworfene Oberflächen in einem Elektronenstrahlsystem eine ausgezeichnete Kompensation liefern. Dieses Kompensationsverfahren für Halbleiterscheiben ist insbesondere dann von großem Vorteil, wenn die bisher üblichen Verfahren zum Glätten einer Halbleiterscheibe unter Verwendung von Vakuum innerhalb solcher Elektronenstrahlsysteme nicht einsetzbar sind, bei denen die gesamte Halbleiterscheibe zum Beschreiben mit einem Muster oder für eine Belichtung im Vakuum liegen muß.

Es ist offensichtlich, daß das hier beschriebene Verfahren auch für die Herstellung von Halbleitermasken benutzt werden kann, wenn eine Kompensation für die Neigung der Maske erwünscht ist. Somit kann dieses Verfahren unter Verwendung von Ausrichtmarken auf der Maske beispielsweise für das Durchstechen der Maske benutzt werden und erlaubt eine Brennweitenkorrektur für einen bei einer Schräglage der Maske auftretenden Fehler.

**Patentansprüche**

1. Verfahren zur Fokussierung eines Ladungsträgerstrahls auf Halbleiterplättchen, auf deren Oberfläche der Strahl ein Muster schreibt und die Ausrichtmarken aufweisen, die durch den Strahl abgetastet und zur Berechnung von eine Verschiebung des Musters in der Plättchenebene gegenüber einer Sollposition, eine Verdrehung des Musters um eine Senkrechte zur Plättchenebene gegenüber einer Solldrehlage

eine Verzerrung des Musters gegenüber einer Sollform und einen Maßstabfehler des Musters bei Abweichung der Höhenlage der Plättchenebene von einer Sollebene definierenden Faktoren verwendet werden, dadurch gekennzeichnet,

daß nach Maßgabe des Maßstabfehler-Faktors ein elektrisches Korrektursignal gebildet und dieses einer Fokussierspule zugeführt wird, die die Höhenlage des Ladungsträgerstrahl-Brennpunktes an die Isthöhe des jeweiligen Halbleiterplättchens angleicht.

2. Anordnung zur Durchführung des Verfahrens nach Anspruch 1,
    dadurch gekennzeichnet,

daß an Rechenschaltungen zur Berechnung des scheinbaren Maßstabfehlerfaktor ein Digital/Analog-Wandler (111) angeschlossen ist, dessen Ausgangssignal als Höhenkorrektursignal an einem Eingang eines mit dem anderen Eingang geerdeten rückgekoppelten Differentialverstärkers (113) anliegt, der ausgangsseitig mit der Fokussierspule (36) verbunden ist.

## Revendications

1. Procédé pour focaliser un faisceau de porteurs de charge sur des microplaquettes semi-conductrices, à la surface desquelles le faisceau enregistre une configuration, et qui comportent des marques d'alignement qui sont balayées par le faisceau et utilisées pour calculer des facteurs définissant un décalage de la configuration dans le plan de la microplaquette par rapport à une position désirée, une rotation de la configuration autour d'une perpendiculaire par rapport à la position de rotation désirée, une distorsion de la configuration par rapport à une forme désirée, et une erreur d'échelle de la configuration à cause du décalage de la hauteur du plan de microplaquette par rapport à un un plan désiré, caractérisé en ce qu'en fonction du facteur d'erreur d'échelle on forme un signal de correction électrique appliqué à une bobine de focalisation qui adapte la hauteur du foyer du faisceau de porteurs de charge à la hauteur effective de la microplaquette semi-conductrice respective.

2. Dispositif pour réaliser le procédé selon la revendication 1, caractérisé en ce que à des circuits de calcul pour calculer le facteur d'erruer d'échelle apparent est connecté un convertisseur numérique-analogique (111) dont le signal de sortie est appliqué, comme signal de correction de hauteur, à une entrée d'un amplificateur différentiel (113) couplé par réaction dont l'autre entrée est à la masse et dont la sortie est connectée à la bobine de focalisation (36).

## Claims

1. A method of focusing a beam of charged particles with respect to a chip on whose surface the beam writes a pattern and having registration marks which are scanned by the beam and are used to calculate factors defining a displacement of the pattern in the chip plane relative to a desired position, a rotation of the pattern about a vertical to the chip plane as opposed to a desired rotational position, a distortion of the pattern relative to a desired shape, and a scaling error of the pattern if the height of the chip plane differs from a desired plane,
    characterized in
    that in accordance with a scaling factor, an electric correction signal is formed and applied to a focus coil adapting the height of the focus of the beam of charged particles to the actual height of the respective chip.

2. An arrangement for implementing the method according to claim 1, characterized in
    that means for calculating the apparent scaling error are connected to a digital-to-analog converter (111) whose output signal as a height error correction signal is applied to one input of a feedback differential amplifier (113) having its other input grounded and its output side connected to the focus coil (36).

FIG. 1

FIG. 2

FIG. 3

FIG. 4

FIG. 5

FIG. 6